# EUROPEAN PATENT SPECIFICATION

(11) **EP 4 216 263 B1**
(45) Date of publication and mention of the grant of the patent: **27.05.2026**
(21) Application number: 22859776.1
(22) Date of filing: 12.01.2022
(51) Int. Cl.: H10B 12/00

(54) **MEMORY DEVICE AND FORMING METHOD THEREOF**
SPEICHERVORRICHTUNG UND HERSTELLUNGSVERFAHREN DAFÜR
DISPOSITIF DE MÉMOIRE ET SON PROCÉDÉ DE FABRICATION

(30) Priority: 23.08.2021 CN 202110966709
(43) Date of publication of application: 26.07.2023
(73) Proprietor: Changxin Memory Technologies, Inc., Hefei, Anhui 230601 (CN)
(72) Inventor: GUO, Shuai, Hefei, Anhui 230601 (CN)
(74) Representative: Lavoix
(86) International application number: PCT/CN2022/071630
(87) International publication number: WO 2023/024415

(56) References cited:
- WO-A1-2020/042255
- CN-A- 102 034 761
- CN-U- 209 045 570
- JP-A- 2013 098 295
- US-A1- 2004 201 055
- US-A1- 2006 172 483
- US-A1- 2011 003 447
- US-A1- 2011 298 046
- US-A1- 2012 094 455
- US-A1- 2012 112 270
- US-A1- 2013 234 240
- US-A1- 2016 093 732

## Description

### Cross-Reference to Related Applications

The present application claims the priority to Chinese Patent Application No. 202110966709.7, titled " MEMORY DEVICE AND FORMING METHOD THEREOF", filed with China National Intellectual Property Administration (CNIPA) on August 23, 2021.

### Technical Field

The present application relates to the field of memories, and in particular, to a memory device and a forming method thereof.

### Background

As a commonly used semiconductor memory in computers, a dynamic random access memory (DRAM) is composed of many repeated memory cells. Each memory cell usually includes a capacitor and a transistor. In the transistor, a gate is connected to a word line (WL), a drain is connected to a bit line (BL), and a source is connected to the capacitor. A voltage signal on the WL can control the transistor to turn on or off, and then data information stored in the capacitor is read through the BL, or data information is written into the capacitor through the BL for storage.

In order to improve integration of a memory structure, the transistor in the existing DRAM usually uses a trench-type transistor structure. However, a line width of a transistor structure of the existing trench-type has been minimized and a storage capacity of the DRAM cannot be further improved. Therefore, how to further improve the storage capacity and storage density of the DRAM is an urgent problem to be resolved by those skilled in the art.

Related technologies are discussed in US2011/003447 A1, US2016/093732 A1, US2011/298046 A1, and WO2020/042255 A1.

### Summary

In view of this, the present application provides a novel method of forming a dynamic random access memory device, which can further improve a storage capacity and storage density of the memory device.

A method according to the invention is defined in claim 1.

In some embodiments, the multiple active regions are arranged in rows and columns.

In some embodiments, a formation process of the multiple active regions includes: forming, on the semiconductor substrate, multiple first mask patterns extending along the first direction and parallel to each other, with a first opening formed between adjacent first mask patterns; forming, on the first mask patterns, multiple second mask patterns extending along the second direction and parallel to each other, with a second opening formed between adjacent second mask patterns; etching the first mask pattern along the second opening by using the second mask pattern as a mask, and segmenting the first mask pattern along the second direction, and forming multiple discrete block mask patterns; and etching the semiconductor substrate by using each of the block mask patterns as a mask, and forming, in the semiconductor substrate, the first trench corresponding to the first opening and the second trench corresponding to the second opening, wherein the retained semiconductor substrate between the first trench and the second trench is the multiple active regions.

In some embodiments, the first mask pattern and the second mask pattern are formed by using a self-aligned double patterning process.

In some embodiments, a formation process of the first mask pattern includes: forming a first hard mask layer on the semiconductor substrate; forming, on the first hard mask layer, multiple first strip structures extending along the first direction and arranged parallel to each other; forming a first sacrificial sidewall layer on a sidewall and a top surface of the first strip structure and on the first hard mask layer between the first strip structures; filling each portion between the first strip structures with a first filling layer; removing the first sacrificial sidewall layer on the sidewall surface of the first strip structure, and forming a third opening between the first strip structure and the first filling layer; and etching the first hard mask layer along the third opening, and forming the first opening in the first hard mask layer, and using the retained portion of the first hard mask layer as the first mask pattern.

In some embodiments, a formation process of the second mask pattern includes: forming a second hard mask layer on the semiconductor substrate and the first mask pattern; forming, on the second hard mask layer, multiple second strip structures arranged in parallel along the second direction; forming a second sacrificial sidewall layer on a sidewall and a top surface of the second strip structure and on a surface of the second hard mask layer between the second strip structures; filling each portion between the second strip structures with a second filling layer; removing the second sacrificial sidewall layer on the sidewall surface of the second strip structure, and forming a fourth opening between the second strip structure and a second filling layer; and etching the second hard mask layer along the fourth opening, and forming the second opening in the second hard mask layer, and using the retained portion of the second hard mask layer as the second mask pattern.

In some embodiments, the width of the third trench is 1/4 to 3/4 of the width of the bottom of the first trench.

In some embodiments, a formation process of the third trench includes: forming a third mask layer in the first trench, with a sixth opening formed in the third mask layer, extending along the first direction, and exposing a surface of a portion of the semiconductor substrate at the bottom of the first trench; and etching the semiconductor substrate along the sixth opening, and forming the third trench.

In some embodiments, impurity ions implanted through the first ion implantation are N-type impurity ions or P-type impurity ions, and the first ion implantation has energy of 20 kev to 100 kev, a dose of 1E13 to 1E22 atom/cm2, and an angle of 0 to 20 degrees.

In some embodiments, the source region is formed through second ion implantation, and a type of impurity ions implanted in the source region is the same as a type of impurity ions implanted in the bit line doped region.

In some embodiments, the process of forming, on a surface of the semiconductor substrate, a capacitor connected to the source region includes: forming a third dielectric layer on the active region and the second dielectric layer; forming, in the third dielectric layer, a through hole exposing a surface of the source region; forming a contact plug in the through hole; forming a fourth dielectric layer on the third dielectric layer; forming, in the fourth dielectric layer, a capacitor hole exposing the contact plug; and forming the capacitor in the capacitor hole.

In some embodiments, doping is performed in a well region on the semiconductor substrate, and a type of impurity ions doped in the well region is opposite to a type of impurity ions doped in the source region and a type of impurity ions doped in the bit line doped region.

According to the method of forming a memory device provided in some embodiments described above in the present application, multiple active regions are formed in the semiconductor substrate, and after the multiple active regions are separated by multiple first trenches extending along a first direction and multiple second trenches extending along a second direction, a third trench extending along the first direction is formed in a portion of the semiconductor substrate at the bottom of each of the first trenches, where a width of the third trench is less than a width of the bottom of the first trench; bit line doped regions are formed in portions of the semiconductor substrate on two sides of the third trench and at the bottom of the first trench through an ion implantation process; a gate dielectric layer is formed on sidewall surfaces and a bottom surface of each of the first trench and the second trench; a first dielectric layer that fills the third trench is formed; a metal gate is formed in each of the first trench on the first dielectric layer and the second trench, where a top surface of the metal gate is lower than a top surface of the active region; a portion of each of the first trench and the second trench above the metal gate is filled with a second dielectric layer; a portion of the metal gate in the second trench is etched to segment the metal gate in the second trench along the second direction; a source region is formed on the top surface of the active region; and a capacitor connected to the source region is formed on a surface of the semiconductor substrate. In a manufacturing process of a memory device in the present application, multiple vertical transistors are formed through the foregoing process, and each vertical transistor includes a corresponding active region, a gate dielectric layer located on a sidewall surface of the active region, bit line doped regions located in portions of a semiconductor substrate at the bottom of a first trench and on two sides of a third trench, a source region located on a top surface of the active region, and a metal gate located in each of the first trench and a second trench and surrounding the active region. In the foregoing vertical transistor of a specific structure, a source region and a drain region are located on an upper side and a lower side of the active region, and a formed channel region is located on a sidewall of the active region, such that an area of the semiconductor substrate occupied by the vertical transistor is relatively small, a quantity of vertical transistors formed per unit area can be increased, and correspondingly, a quantity of capacitors connected to the source region of each transistor and subsequently formed per unit area can also be increased, thereby improving a storage capacity and storage density of a memory. In addition, use of the vertical transistor of such a specific structure can reduce a body effect, reduce a leakage current generated by a subsequently formed capacitor into the substrate, and improve electrical properties of the memory device.

### Brief descriptions of the drawings

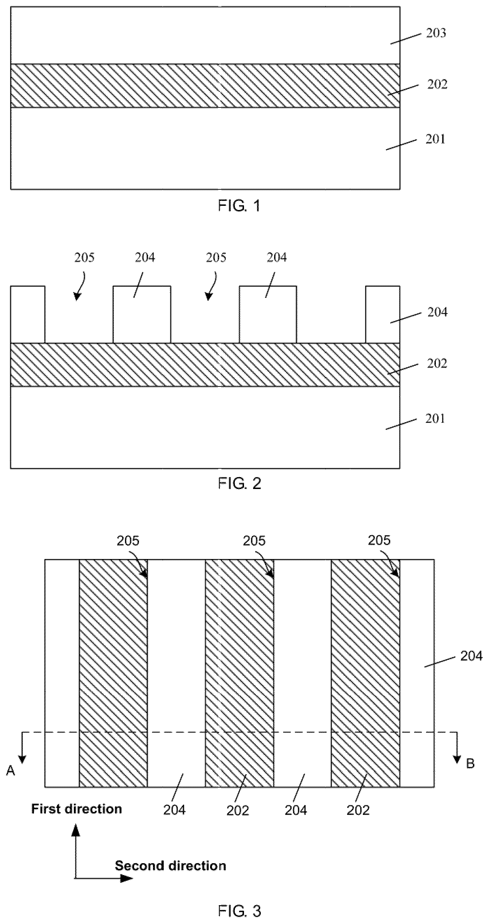

FIG. 1 to FIG. 39 are each a schematic structural diagram of a formation process of a memory device according to an embodiment of the present application.

### Detailed Description

As described in the background, how to further improve the storage capacity and storage density of the DRAM is an urgent problem to be resolved by those skilled in the art.

Researches have found that a trench-type transistor usually includes at least one buried word line located in a semiconductor substrate and one drain region and at least one source region located in portions of the semiconductor substrate on two sides of the buried word line. Such a trench-type transistor occupies a relatively large area of the semiconductor substrate, which is not conducive to improvement of integration of the DRAM, thus limiting the storage capacity and storage density of the DRAM.

Therefore, the present application provides a novel memory device and a forming method thereof, which can further improve a storage capacity and storage density of the memory device.

To make the above objectives, features and advantages of the present application clearer, specific implementations of the present application will be described below in detail with reference to accompanying drawings. In detailed descriptions on embodiments of the present application, schematic views are not partially enlarged according to a general proportion for ease of descriptions. The schematic views merely serve as examples, rather than limitations to the scope of protection of the present application. In addition, dimensions in a three-dimensional (3D) space including a length, width and depth should be provided in actual manufacture.

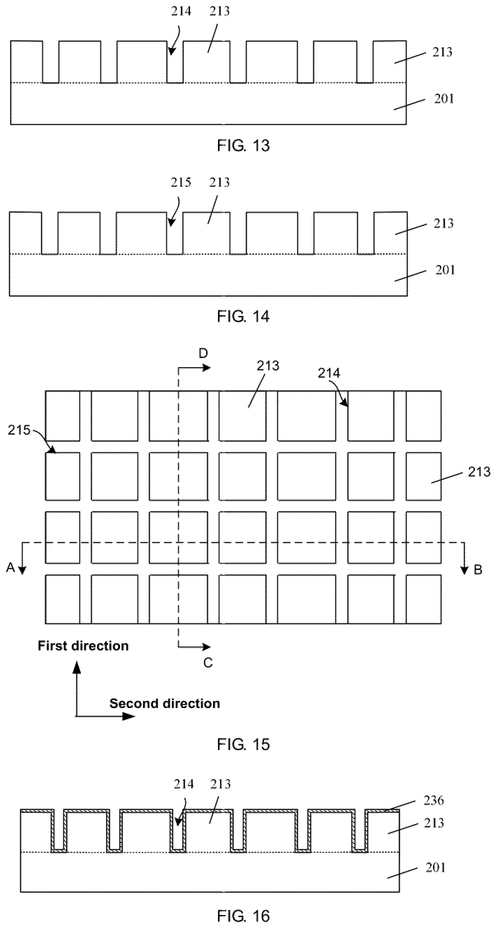

Referring to FIG. 13 to FIG. 15, FIG. 13 is a schematic structural diagram of a cross section of FIG. 15 along a direction of a cutting line AB, FIG. 14 is a schematic structural diagram of a cross section of FIG. 15 along a direction of a cutting line CD, and a semiconductor substrate 201 is provided. Multiple active regions 213 are formed in the semiconductor substrate 201, and the multiple active regions 213 are separated by multiple first trenches 214 extending along a first direction and multiple second trenches 215 extending along a second direction. The first trench 214 communicates with the corresponding second trench 215.

A material of the semiconductor substrate 201 may be silicon (Si), germanium (Ge), silicon-germanium (GeSi), or silicon carbide (SiC); or may be silicon on insulator (SOI) or germanium on insulator (GOI); or may be another material such as gallium arsenide or other III-V compounds. In this embodiment, the material of the semiconductor substrate 201 is silicon. The semiconductor substrate 201 needs to be doped with some impurity ions according to a type of a subsequently formed vertical transistor. For example, doping may be performed in a well region on the semiconductor substrate. The impurity ions may be N-type impurity ions or P-type impurity ions. The P-type impurity ions are one or more of boron ions, gallium ions, or indium ions. The N-type impurity ions are one or more of phosphorus ions, arsenic ions, or antimony ions.

The active region 213 is subsequently used to form a channel region of the vertical transistor. The multiple active regions 213 are discrete, and adjacent active regions 213 separated by cross-distributed first trenches 214 and second trenches 215.

In some embodiments, the formed active regions 213 are arranged in rows and columns (referring to FIG. 15). In other embodiments, the active regions may be arranged in another manner.

In some embodiments, the first direction and the second direction are perpendicular to each other and have an angle of 90 degrees. In other embodiments, the first direction and the second direction may not be perpendicular to each other. For example, an angle between the first direction and the second direction may be an acute angle.

In some embodiments, the semiconductor substrate 201 may be first etched to form multiple first trenches 214, and then the semiconductor substrate 201 is etched to form multiple second trenches 215, thereby forming multiple discrete active regions 213. In other embodiments, the first trench 214 and the second trench 215 may be formed simultaneously by etching the semiconductor substrate 201.

In this embodiment, the multiple active regions 213 are formed by using a self-aligned double patterning mask process. A formation process of the active region 213 is described in detail below with reference to FIG. 1 to FIG. 15.

Referring to FIG. 1, a first hard mask layer 202 is formed on the semiconductor substrate 201; and a first material layer 203 is formed on the first hard mask layer 202.

The first hard mask layer 202 is subsequently used to form a first mask pattern. In some embodiments, the first hard mask layer 202 may be of a single-layer structure or a multi-layer stacked structure. A material of the first hard mask layer 202 may be one or more of polycrystalline silicon, amorphous silicon, amorphous carbon, silicon nitride, silicon oxynitride, silicon oxide, silicon nitride bonded silicon carbide, silicon oxycarbide, silicon carbide, and silicon-germanium. A process of forming the first hard mask layer 202 may be atmospheric or low pressure chemical vapor deposition (CVD), plasma enhanced chemical vapor deposition (PECVD), thermal chemical vapor deposition (Thermal CVD), physical vapor deposition (PVD), atomic layer deposition (ALD), sputtering, metallization, electroplating, spin coating, other suitable methods, and/or a combination thereof. In this embodiment, the material of the first hard mask layer 202 is polycrystalline silicon.

In some embodiments, a first etching stop layer (not shown in the figure) may further be formed between the first hard mask layer 202 and the semiconductor substrate 201. The first etching stop layer is used to protect an underlying material layer from being over-etched during patterning of the first hard mask layer. A material of the first etching stop layer is different from that of the first hard mask layer. The material of the first etching stop layer is one or more of silicon nitride, silicon oxynitride, silicon oxide, silicon nitride bonded silicon carbide, and silicon oxycarbide. In this embodiment, the material of the first etching stop layer is silicon oxide.

The first material layer 203 is subsequently used to form a first strip structure. In some embodiments, the first material layer 203 may be of a single-layer structure or a multi-layer stacked structure. A material of the first material layer 203 may be one or more of polycrystalline silicon, amorphous silicon, amorphous carbon, silicon nitride, silicon oxynitride, silicon oxide, silicon nitride bonded silicon carbide, silicon oxycarbide, silicon carbide, and silicon-germanium. In this embodiment, the material of the first material layer 203 is amorphous carbon.

In some embodiments, a second etching stop layer (not shown in the figure) may further be formed between the first material layer 203 and the first hard mask layer 202. The second etching stop layer is used to protect an underlying material layer from being over-etched during patterning of the first material layer 203. A material of the second etching stop layer is different from that of the first material layer 203. The material of the second etching stop layer is one or more of silicon nitride, silicon oxynitride, silicon oxide, silicon nitride bonded silicon carbide, and silicon oxycarbide. In this embodiment, the material of the second etching stop layer is silicon oxynitride.

Referring to FIG. 2 and FIG. 3, FIG. 2 is a schematic structural diagram of a cross section of FIG. 3 along a direction of a cutting line AB. The first material layer 203 (referring to FIG. 1) is patterned. Multiple first strip structures 204 extending along the first direction and arranged parallel to each other are formed on the first hard mask layer.

The first strip structure 204 is elongated. The multiple first strip structures 204 are discrete and parallel to each other. A fourth opening 205 is formed between adjacent first strip structures 204.

In some embodiments, the first material layer 203 is patterned by using an anisotropic dry etching process, and specifically, an anisotropic plasma etching process may be used.

In some embodiments, before the first material layer 203 is patterned, a patterned photoresist layer (not shown in the figure) may further be formed on the first material layer 203, and the first material layer 203 is etched by using the patterned photoresist layer as a mask to form a first strip structure 204; and the patterned photoresist layer is removed.

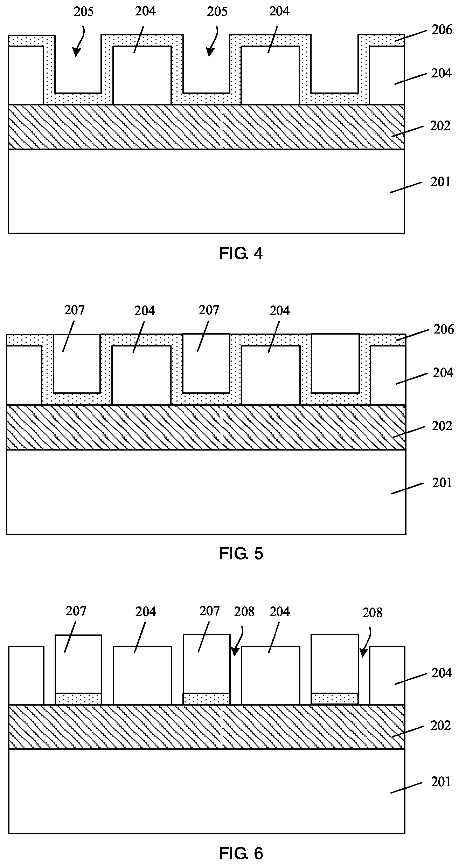

Referring to FIG. 4, FIG. 4 is performed on the basis of FIG. 2, and a first sacrificial sidewall layer 206 is formed on sidewall and top surfaces of the first strip structure 204 and on a portion of the first hard mask layer 202 between first strip structures 204.

A material of the first sacrificial sidewall layer 206 is different from that of the first strip structure. The material of the first sacrificial sidewall layer 206 may be one or more of polycrystalline silicon, amorphous silicon, amorphous carbon, silicon nitride, silicon oxynitride, silicon oxide, silicon nitride bonded silicon carbide, silicon oxycarbide, silicon carbide, and silicon-germanium. The first sacrificial sidewall layer 206 is formed by using a deposition process. The deposition process includes an atomic layer deposition process.

Referring to FIG. 5, each portion between the first strip structures 204 is filled with a first filling layer 207, and the first filling layer 207 fills the remaining portion of the fourth opening.

Subsequently, a third opening is formed between the first strip structure 204 and the first filling layer 207 by removing portions of the first sacrificial sidewall layer on the sidewall surfaces of the first strip structure 204.

A material of the first filling layer 207 is different from that of the first sacrificial sidewall layer 206. In some embodiments, the material of the first filling layer 207 may be one or more of polycrystalline silicon, amorphous silicon, amorphous carbon, silicon nitride, silicon oxynitride, silicon oxide, silicon nitride bonded silicon carbide, silicon oxycarbide, silicon carbide, silicon-germanium, and an organic material. A process of forming the first filling layer 207 may be atmospheric or low pressure CVD, PECVD, thermal CVD, PVD, ALD, sputtering, metallization, electroplating, spin coating, other suitable methods, and/or a combination thereof.

In some embodiments, a surface of the formed first filling layer 207 may be flush with the first sacrificial sidewall layer 206 on the top surface of the first strip structure 204. Specifically, after a first filling material layer covering the first sacrificial sidewall layer 206 and filling the remaining portion of the fourth opening is formed, a portion of the first filling layer above the first sacrificial sidewall layer 206 on the top surface of the first strip structure 204 is removed by using a chemical-mechanical mask process. The remaining portion of the first filling material layer in the fourth opening is used as the first filling layer 207.

In some embodiments, a surface of the formed first filling layer may be flush with the top surface of the first strip structure 204. Specifically, after a first filling material layer covering the first sacrificial sidewall layer 206 and filling the remaining portion of the fourth opening is formed, a portion of the first sacrificial sidewall layer 206 and the first filling material layer above the top surface of the first strip structure 204 are removed by using a chemical-mechanical mask process, to expose the top surface of the first strip structure 204, and the remaining portion of the first filling material layer in the fourth opening is used as the first filling layer. Therefore, a top surface of the formed first filling layer is flush with the top surface of the first strip structure. After the third opening is subsequently formed, during etching of the first hard mask layer, an etching load effect caused by a height difference between the filling layer and the first strip structure can be alleviated, accuracy of positions and sizes of the formed first mask patterns can be improved, and a favorable sidewall shape can be maintained, such that positions and sizes of block mask patterns formed after the first mask patterns are segmented have relatively high accuracy and a favorable sidewall shape is maintained, and finally, positions and sizes of active regions formed by etching the semiconductor substrate by using each of the block mask patterns as a mask have relatively high accuracy and a favorable sidewall shape is maintained.

Referring to FIG. 6, portions of the first sacrificial sidewall layer on the sidewall surfaces of the first strip structure 204 are removed, to form a third opening 208 between the first strip structure 204 and the first filling layer 207.

In some embodiments, the portions of the first sacrificial sidewall layer on the sidewall surfaces of the first strip structure 204 are removed by using an anisotropic dry etching process, including an anisotropic plasma etching process.

It should be noted that, in some embodiments, during the removal of the portions of the first sacrificial sidewall layer on the sidewall surfaces of the first strip structure 204, the portion of the first sacrificial sidewall layer on the top surface of the first strip structure 204 is also removed.

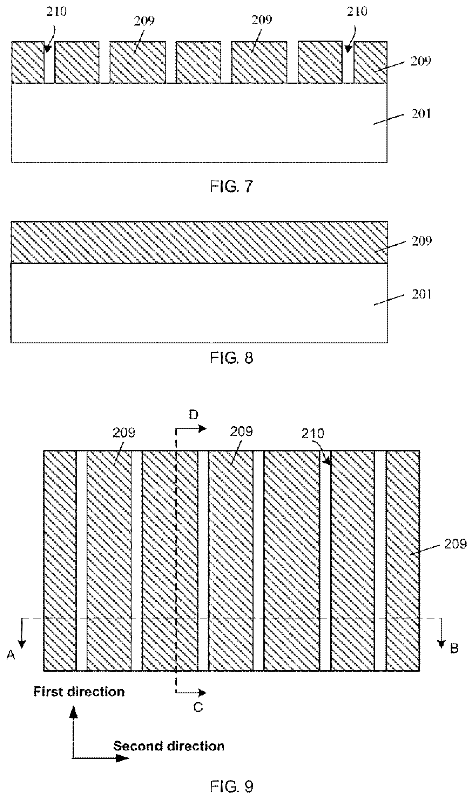

Referring to FIG. 7 to FIG. 9, FIG. 7 is performed on the basis of FIG. 6, FIG. 7 is a schematic structural diagram of a cross section of FIG. 9 along a direction of a cutting line AB, and FIG. 8 is a schematic structural diagram of a cross section of FIG. 9 along a direction of a cutting line CD. The first hard mask layer 202 (referring to FIG. 6) is etched along the third opening 208 (referring to FIG. 6), to form the first opening 210 in the first hard mask layer, and the retained portion of the first hard mask layer is used as the first mask pattern 209.

In some embodiments, the first hard mask layer 202 is etched by using an anisotropic dry etching process, including an anisotropic plasma etching process.

The formed multiple first mask patterns 209 are discrete. Specifically, the formed first mask patterns 209 extend along the first direction and are parallel to each other, and a first opening 210 is formed between adjacent first mask patterns 209.

In the present application, the foregoing first mask pattern 209 is formed by using the foregoing self-aligned double patterning process, and subsequently, during the formation of the active region, a width of the first trench between active regions can be made relatively small, thereby allowing an area of the active region to be relatively large.

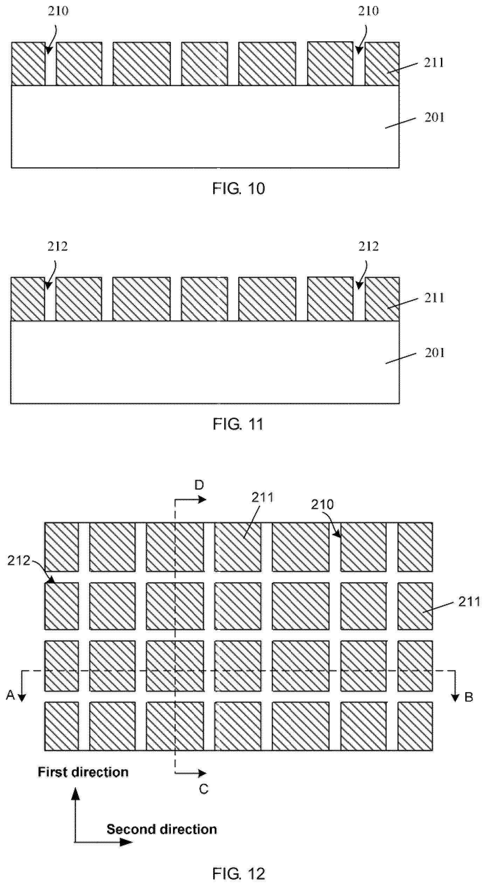

Referring to FIG. 10 to FIG. 12, FIG. 10 is a schematic structural diagram of a cross section of FIG. 12 along a direction of a cutting line AB, and FIG. 11 is a schematic structural diagram of a cross section of FIG. 12 along a direction of a cutting line CD. The first mask patterns 209 (referring to FIG. 7 to FIG. 9) are segmented along the second direction to form multiple discrete block mask patterns 211.

The first mask patterns 209 (referring to FIG. 7 to FIG. 9) are segmented along the second direction by using an anisotropic dry etching process. In some embodiments, before the first mask patterns 209 are segmented along the second direction, multiple second mask patterns extending along the second direction and parallel to each other are formed on the first mask pattern 209 and are each used as a mask for etching the first mask patterns 209, and a second opening is formed between adjacent second mask patterns; the first mask patterns 209 are etched along the second opening by using each of the second mask patterns as a mask, to segment the first mask patterns along the second direction to form multiple discrete block mask patterns 211; and the second mask patterns are removed.

In some embodiments, the second mask pattern may be formed by using a self-aligned double patterning process. A specific process includes: A formation process of the second mask pattern includes: forming a second hard mask layer on the semiconductor substrate and the first mask pattern; forming, on the second hard mask layer, multiple second strip structures arranged in parallel along the second direction; form a second sacrificial sidewall layer on a sidewall and top surfaces of the second strip structure and on a surface of a portion of the second hard mask layer between second strip structures; filling each portion between the second strip structures with a second filling layer; removing portions of the second sacrificial sidewall layer on the sidewall surfaces of the second strip structure, to form a fourth opening between the second strip structure and a second filling layer; and etching the second hard mask layer along the fourth opening, to form the second opening in the second hard mask layer, and using the retained portion of the second hard mask layer as the second mask pattern.

A material of the second hard mask layer may be one or more of polycrystalline silicon, amorphous silicon, amorphous carbon, silicon nitride, silicon oxynitride, silicon oxide, silicon nitride bonded silicon carbide, silicon oxycarbide, silicon carbide, and silicon-germanium. A process of forming the second hard mask layer may be atmospheric or low pressure CVD, PECVD, thermal CVD, PVD, ALD, sputtering, metallization, electroplating, spin coating, other suitable methods, and/or a combination thereof.

In some embodiments, a fourth etching stop layer may further be formed between the second hard mask layer and the first mask pattern 209. A material of the fourth etching stop layer is different from that of the second hard mask layer. The material of the fourth etching stop layer is one or more of silicon nitride, silicon oxynitride, silicon oxide, silicon nitride bonded silicon carbide, and silicon oxycarbide.

A material of the second strip structure may be one or more of polycrystalline silicon, amorphous silicon, amorphous carbon, silicon nitride, silicon oxynitride, silicon oxide, silicon nitride bonded silicon carbide, silicon oxycarbide, silicon carbide, and silicon-germanium. In some embodiments, the second strip structure may be formed by etching a second material layer located on the second hard mask layer. In some embodiments, a fifth etching stop layer may be further formed between the second material layer and the second hard mask layer. A material of the fifth etching stop layer is different from that of the second material layer. The material of the fifth etching stop layer is one or more of silicon nitride, silicon oxynitride, silicon oxide, silicon nitride bonded silicon carbide, and silicon oxycarbide.

A material of the second sacrificial sidewall layer is different from that of the second strip structure. The material of the second sacrificial sidewall layer may be one or more of polycrystalline silicon, amorphous silicon, amorphous carbon, silicon nitride, silicon oxynitride, silicon oxide, silicon nitride bonded silicon carbide, silicon oxycarbide, silicon carbide, and silicon-germanium. The second sacrificial sidewall layer is formed by using a deposition process. The deposition process includes an atomic layer deposition process.

A material of the second filling layer is different from that of the second sacrificial sidewall layer. In some embodiments, the material of the second filling layer may be one or more of polycrystalline silicon, amorphous silicon, amorphous carbon, silicon nitride, silicon oxynitride, silicon oxide, silicon nitride bonded silicon carbide, silicon oxycarbide, silicon carbide, silicon-germanium, and an organic material. A process of forming the second filling layer may be atmospheric or low pressure CVD, PECVD, thermal CVD, PVD, ALD, sputtering, metallization, electroplating, spin coating, other suitable methods, and/or a combination thereof.

In some embodiments, a surface of the formed second filling layer may be flush with the second sacrificial sidewall layer on the top surface of the second strip structure. Specifically, after a second filling material layer covering the second sacrificial sidewall layer and filling a space between second strip structures is formed, a portion of the second filling layer above the surface of the second sacrificial sidewall layer on the top surface of the second strip structure is removed by using a chemical-mechanical mask process. The remaining portion of the second filling material layer between the second strip structures is used as the second filling layer.

In some embodiments, a surface of the formed second filling layer may be flush with the top surface of the second strip structure. Specifically, after a second filling material layer covering the second sacrificial sidewall layer and filling a space between second strip structures is formed, a portion of the second sacrificial sidewall layer and the second filling material layer above the top surface of the second strip structure are removed by using a chemical-mechanical mask process, to expose the top surface of the second strip structure, and the remaining portion of the second filling material layer in the space between the second strip structures is used as the second filling layer. Therefore, a top surface of the formed second filling layer is flush with the top surface of the second strip structure. After the fourth opening is subsequently formed, during etching of the second hard mask layer, an etching load effect caused by a height difference between the filling layer and the second strip structure can be alleviated, accuracy of positions and sizes of the formed second mask patterns can be improved, and a favorable sidewall shape can be maintained, such that positions and sizes of block mask patterns formed after the first mask patterns are segmented have relatively high accuracy and a favorable sidewall shape is maintained, and finally, positions and sizes of active regions formed by etching the semiconductor substrate by using each of the block mask patterns as a mask have relatively high accuracy and a favorable sidewall shape is maintained.

In some embodiments, the portions of the first sacrificial sidewall layer on the sidewall surfaces of the second strip structure are removed by using an anisotropic dry etching process, including an anisotropic plasma etching process.

Referring to FIG. 13 to FIG. 15, FIG. 13 is a schematic structural diagram of a cross section of FIG. 15 along a direction of a cutting line AB, and FIG. 14 is a schematic structural diagram of a cross section of FIG. 15 along a direction of a cutting line CD. The semiconductor substrate 201 is etched by using each of the block mask patterns (referring to FIG. 11) as a mask, to form, in the semiconductor substrate 201, first trenches 214 corresponding to the first openings and second trenches 215 corresponding to the second openings. Multiple first trenches 214 extend along the first direction and are parallel to each other. Multiple second trenches 215 extend along the second direction and are parallel to each other. Each first trench 214 communicates with a corresponding second trench 215. The retained portions of the semiconductor substrate between the first trenches 214 and the second trenches 215 are multiple active regions 213.

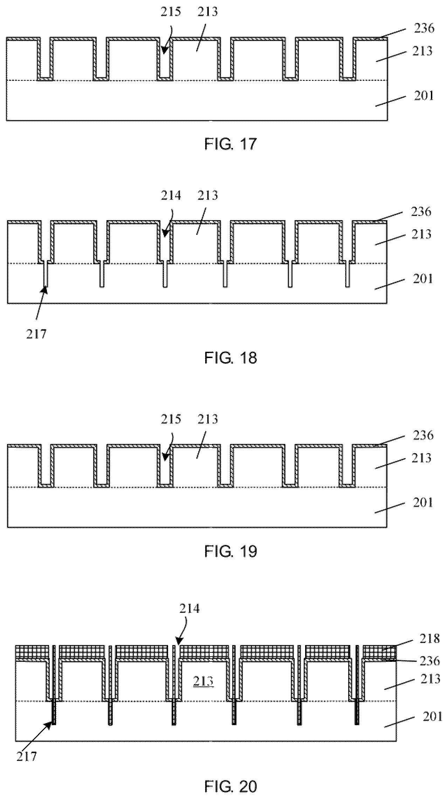

In some embodiments, referring to FIG. 16 and FIG. 17, FIG. 16 is performed on the basis of FIG. 13, FIG. 17 is performed on the basis of FIG. 14, and a protective layer 236 is formed on each of a surface of the active region 213 and sidewall and bottom surfaces of the first trench and the second trench.

The protective layer 236 protects the active region 213 during a subsequent process (etching, implantation, or other processes). A material of the protective layer 236 may be one or more of silicon oxide, silicon nitride, silicon oxynitride, and silicon nitride bonded silicon carbide. In this embodiment, the material of the protective layer 236 may be silicon oxide, and the protective layer 236 may be formed by using a furnace tube oxidation process, a thermal oxidation process, or a deposition process.

Referring to FIG. 18 and FIG. 19, a third trench 217 extending along the first direction is formed in a portion of the semiconductor substrate 201 at the bottom of the first trench 214. A width of the third trench 217 is less than a width of the bottom of the first trench 214.

The third trench 217 is formed for the purpose of separating adjacent active regions 213 that are arranged along the second direction, and defining positions of bit line doped regions (specifically, portions of the semiconductor substrate on two sides of the third trench are used as bit line doped regions of corresponding transistors).

Each portion of the semiconductor substrate 201 at the bottom of the first trench 214 has a corresponding third trench 217. A width of the third trench 217 is less than the width of the bottom of the first trench 214. In some embodiments, the width of the second trench 217 is 1/4 to 3/4 of the width of the bottom of the first trench 214.

In some embodiments, the portion of the semiconductor substrate 201 at the bottom of the first trench 214 is etched to form the third trench 217 extending along the first direction. Before the semiconductor substrate 201 is etched, a third mask layer is formed in the first trench 214 and on the semiconductor substrate 201, and a sixth opening extending along the first direction and exposing a surface of a portion of the semiconductor substrate 201 at the bottom of the first trench 214 is formed in the third mask layer. The semiconductor substrate 201 is etched along the sixth opening to form the third trench 217. The etching is anisotropic dry etching, and may anisotropic plasma etching. The third mask layer is removed.

Referring to FIG. 20 to FIG. 23, bit line doped regions 217 are formed in portions of the semiconductor substrate 201 on two sides of the third trench 217 and at the bottom of the first trench 214 through an ion implantation process.

The bit line doped region 217 is subsequently used as a bit line of a memory, a portion of the bit line doped region in contact with each active region 213 may be used as a drain region of a subsequently formed vertical transistor in each active region, and after the vertical transistor is subsequently formed, the bit line may be used to perform a read or write operation on a row of memories arranged along the first direction.

The bit line doped region 217 is formed through ion implantation. A type of impurity ions implanted in the bit line doped region 217 is different from a type of impurity ions implanted in the active region 213. For example, when P-type impurity ions are implanted in the active region 213, N-type impurity ions are implanted in the bit line doped region 217, or when N-type impurity ions are implanted in the active region 213, P-type impurity ions are implanted in the bit line doped region 217. The impurity ions implanted in the bit line doped region 217 are N-type impurity ions or P-type impurity ions. The P-type impurity ions are one or more of boron ions, gallium ions, or indium ions. The N-type impurity ions are one or more of phosphorus ions, arsenic ions, or antimony ions.

Before the ion implantation is performed, referring to FIG. 20 and FIG. 21, a fourth mask layer 238 is formed in the third trench 217 and on the top surface of the active region 213, and a seventh opening extending along the first direction and exposing the portions of the semiconductor substrate 201 on the two sides of the third trench 217 is formed in the fourth mask layer 238. Referring to FIG. 22 and FIG. 23, first ion implantation is formed on a portion of the semiconductor substrate 201 at the bottom of the seventh opening along the seventh opening, and the bit line doped regions 218 are formed in the portions of the semiconductor substrate 201 on the two sides of the third trench 217 and at the bottom of the first trench 214. After the formation of the bit line doped regions 218, the fourth mask layer 238 is removed. The bit line doped regions 218 are distributed in the portions of the semiconductor substrate 201 on two sides of the active region 213, such that a control capability of the bit line can be improved and electrical properties of the memory can be improved.

In some embodiments, the first ion implantation has energy of 20 kev to 100 kev, a dose of 1E13 to 1E22 atom/cm2, and an angle of 0 degrees to 20 degrees.

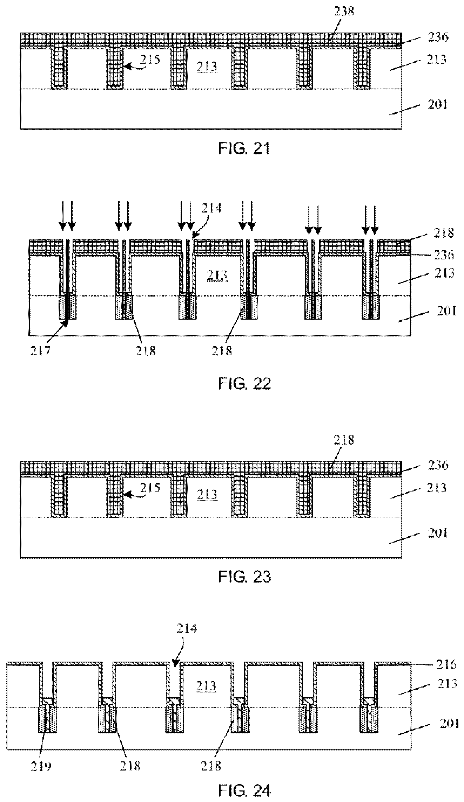

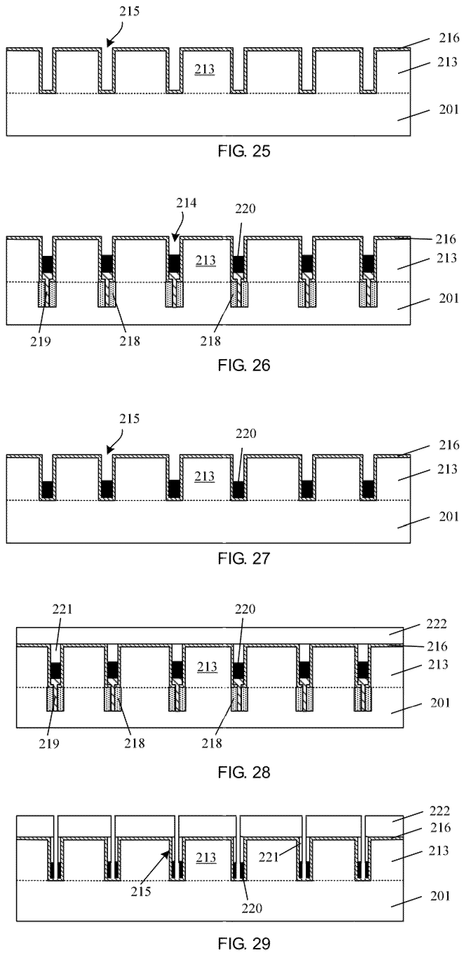

Referring to FIG. 24 and FIG. 25, a gate dielectric layer 216 is formed on sidewall surfaces and a bottom surface of each of the first trench 214 and the second trench 215.

A material of the gate dielectric layer 216 may be silicon oxide or a high-K (dielectric constant) dielectric material. The high-K dielectric material is one or more of HfO2, TiO2, HfZrO, HfSiNO, Ta2O5, ZrO2, ZrSiO2, Al2O3, SrTiO3, or BaSrTiO.

The gate dielectric layer 216 may be formed by using an oxidation process or a deposition process.

In some embodiments, the gate dielectric layer 216 may be formed after the removal of the protective layer 236. In another embodiment, a gate dielectric layer may be formed directly on the protective layer 236 without removing the protective layer 236.

In some embodiments, during formation of the gate dielectric layer 216, the gate dielectric layer 216 may alternatively be formed on sidewall and bottom surfaces of the third trench or directly fill the third trench.

In some embodiments, when the third trench is not filled with a gate dielectric layer material, still referring to FIG. 24, after formation of the gate dielectric layer 216, a first dielectric layer 219 that fills the third trench is formed.

The formed first dielectric layer 219 is used for electrical isolation between adjacent bit line doped regions 218. In some embodiments, a material of the first dielectric layer 219 is silicon oxide, silicon nitride, silicon oxynitride, fluorine-doped silica glass (FSG), a low dielectric constant (where K is less than 2.8) material, other suitable materials, and/or a combination thereof.

In some embodiments, a formation process of the first dielectric layer 219 includes: forming a first dielectric material layer on a surface of the active region 213 and in the first trench 214, the second trench 215, and the third trench by using a deposition process; and etching back to remove a portion of the first dielectric material layer, to form the first dielectric layer 219 that fills the third trench.

In some embodiments, the formed first dielectric layer 219 fills the third trench, and a surface of the first dielectric layer 219 may be higher than an opening of the third trench and partially located in the first trench 214.

Referring to FIG. 26 and FIG. 27, a metal gate 220 is formed in each of the first trench 214 on the first dielectric layer 219 and the second trench 215. A top surface of the metal gate 220 is lower than a top surface of the active region 213.

The formed metal gate 220 is located in the second trench 215 and the first trench 214, that is, the formed metal gate 220 surrounds sidewalls of each active region, such that a capability of the metal gate 220 to control the formation of a trench in the sidewall of the active region can be improved, and performance of forming a vertical transistor can be improved.

In some embodiments, a material of the metal gate 220 may be one or more of W, Al, Cu, Ag, Au, Pt, Ni, Ti, TiN, TaN, Ta, TaC, TaSiN, WN, and Wsi.

In some embodiments, a formation process the metal gate 220 is: forming a metal layer in the first trench and the second trench and on a surface of the active region; and etching back to remove a portion of the metal layer, and using the remaining metal layer in the first trench and the second trench as the metal gate 220, where a surface of the metal gate 220 is lower than the top surface of the active region 213.

Referring to FIG. 28 and FIG. 29, a portion of each of the second trench and the first trench above the metal gate 220 is filled with a second dielectric layer 221; and a portion of the metal gate 220 in the second trench 215 is etched to segment the metal gate 220 in the second trench along the second direction.

The metal gate 220 is segmented along the second direction, such that multiple sub-metal gates extending along the second direction and parallel to each other can be formed, and each sub-metal gate can correspondingly control multiple vertical transistors formed in multiple active regions in a row along the second direction.

In some embodiments, a portion of the metal gate 220 in the second trench is segmented along the second direction, to form a fifth mask layer 222 on a surface of the second dielectric layer 221 and a top surface of the active region 213, and an eighth opening extending along the second direction and exposing a surface of a portion of the second dielectric layer 221 in the second trench is formed in the fifth mask layer 222; and portions of the second dielectric layer 221 and the metal gate 220 in the second trench are etched along the eighth opening to segment the metal gate in the second trench.

In some embodiments, a material of the second dielectric layer 221 is silicon oxide, silicon nitride, silicon oxynitride, FSG, a low dielectric constant (where K is less than 2.8) material, other suitable materials, and/or a combination thereof.

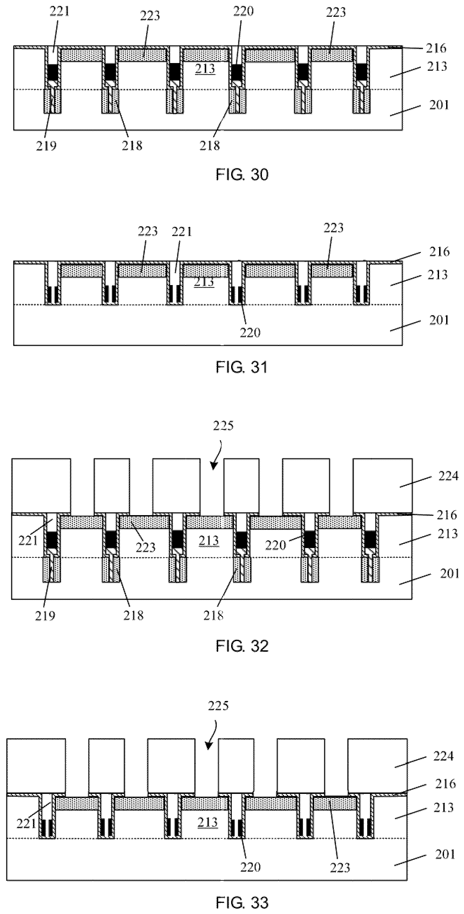

Referring to FIG. 30 and FIG. 31, the fifth mask layer 222 (referring to FIG. 28 and FIG. 29) is removed; gaps of the segmented metal gate 220 and the second trench are filled with a dielectric material, and the filled dielectric material is used as a portion of the second dielectric layer 221; and a source region 223 is formed on the top surface of the active region 213.

A type of impurity ions doped in the source region 223 is the same as a type of impurity ions doped in the bit line doped region 218, and is different from the type of the impurity ions doped in the foregoing well region. The source region 223 is formed by using a second ion implantation process. The impurity ions implanted (doped) in the bit line doped region 217 are N-type impurity ions or P-type impurity ions. The P-type impurity ions are one or more of boron ions, gallium ions, or indium ions. The N-type impurity ions are one or more of phosphorus ions, arsenic ions, or antimony ions.

In the present application, multiple vertical transistors are formed through the foregoing process, and each vertical transistor includes a corresponding active region 213, a gate dielectric layer 216 located on a sidewall surface of the active region 213, bit line doped regions 218 located in portions of a semiconductor substrate at the bottom of a first trench and on two sides of a third trench, a source region 223 located on a top surface of the active region 213, and a metal gate 220 located in each of the first trench and a second trench and surrounding the active region 213. In the foregoing vertical transistor of a specific structure, a source region and a drain region are located on an upper side and a lower side of the active region, and a formed channel region is located on a sidewall of the active region, such that an area of the semiconductor substrate occupied by the vertical transistor is relatively small, a quantity of vertical transistors formed per unit area can be increased, and correspondingly, a quantity of capacitors connected to the source region of each transistor and subsequently formed per unit area can also be increased, thereby improving a storage capacity and storage density of a memory. In addition, use of the vertical transistor of such a specific structure can reduce a body effect, reduce a leakage current generated by a subsequently formed capacitor into the substrate, and improve electrical properties of the memory device.

In some embodiments, after formation of the source region 223, the following is further included: forming, on a surface of the semiconductor substrate 201, a capacitor connected to the source region 223.

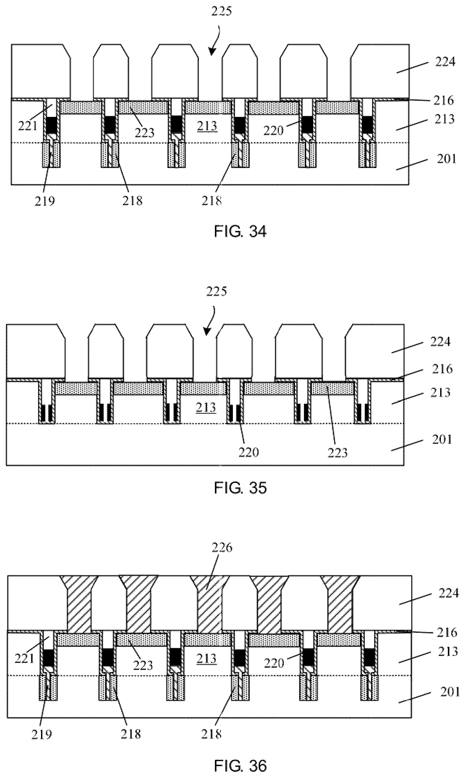

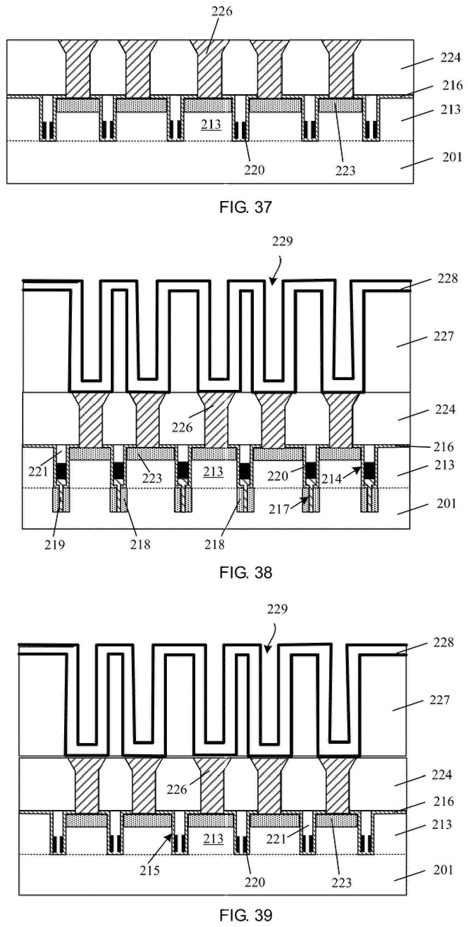

In some embodiments, the process of forming, on a surface of the semiconductor substrate 201, a capacitor connected to the source region 223 includes: referring to FIG. 32 and FIG. 33, forming a third dielectric layer 224 on the active region 213 and the second dielectric layer 221; and forming, in the third dielectric layer 224, a through hole 225 exposing a surface of the source region 223. In some embodiments, after formation of the through hole 225, referring to FIG. 34 and FIG. 34, the following step may further be included: widening an opening of the through hole 225 to facilitate subsequent formation of a contact plug, and to increase a contact area between a top surface of the formed contact plug and the subsequently formed capacitor. Referring to FIG. 36 and FIG. 37, a contact plug 226 is formed in the through hole, and a material of the contact plug 226 is metal. Referring to FIG. 38 and FIG. 39, a fourth dielectric layer 227 is formed on the third dielectric layer 224; a capacitor hole 229 exposing the contact plug is formed in the fourth dielectric layer 227; and a capacitor 228 is formed in the capacitor hole 229.

In some embodiments, the capacitor 228 includes a bottom electrode layer, a dielectric layer located on the bottom electrode layer, and a top electrode layer located on the dielectric layer.

In some embodiments, a material of the dielectric layer may be a high-K dielectric material, so as to increase a capacitance value of the capacitor per unit area. The high-K dielectric material includes one of HfO2, TiO2, HfZrO, HfSiNO, Ta2O5, ZrO2, ZrSiO2, Al2O3, SrTiO3, or BaSrTiO, or a stacked layer formed by at least two of groups including the foregoing materials.

A material of each of the top electrode layer and the bottom electrode layer may be one of tungsten, titanium, nickel, aluminum, platinum, titanium nitride, N-type polycrystalline silicon, and P-type polycrystalline silicon, or a stacked layer formed by at least two of groups including the foregoing materials, or may include a compound formed by one or two of metal nitride and metal silicide, such as titanium nitride, titanium silicide, nickel silicide, or silicon titanium nitride (TiSixNy).

In some other embodiments, the capacitor may alternatively be formed by using an existing double-sided capacitor formation process.

Some embodiments of the present invention further provide a memory device. With reference to FIG. 13 to FIG. 15 and FIG. 38 to FIG. 39, the memory device includes:
a semiconductor substrate 201, where multiple active regions 213 are formed in the semiconductor substrate 201, the multiple active regions 213 are separated by multiple first trenches 214 extending along a first direction and multiple second trenches 215 extending along a second direction, and the first trench 214 communicates with the corresponding second trench 215;
a third trench 217, extending along the first direction and located in a portion of the semiconductor substrate 201 at the bottom of each of the first trenches 214, where a width of the third trench 217 is less than a width of the bottom of the first trench 214;
bit line doped regions 218, located in portions of the semiconductor substrate on two sides of the third trench 217 and at the bottom of the first trench 214;
a gate dielectric layer 216, located on sidewall surfaces of each of the first trench 214 and the second trench 215;
a first dielectric layer 219 that fills the third trench 217;
a metal gate 220, located in each of the first trench 214 on the first dielectric layer 219 and the second trench 215, where a top surface of the metal gate 220 is lower than a top surface of the active region 213, and the metal gate 220 in the second trench 215 is segmented along the second direction;
a second dielectric layer 221 that fills a portion of each of the second trench and the first trench located above the metal gate 220;
a source region 223, located on the top surface of the active region 213; and
a capacitor 228, located on a surface of the semiconductor substrate 201 and connected to the source region 223.

In some embodiments, the multiple active regions 213 are arranged in rows and columns.

In some embodiments, the width of the third trench 217 is 3/4 to 1/4 of the width of the bottom of the first trench 214.

In some embodiments, impurity ions doped in the bit line doped region 218 are N-type impurity ions or P-type impurity ions. A type of impurity ions doped in the source region 223 is the same as a type of the impurity ions doped in the bit line doped region 218 and different from a type of impurity ions in a well region formed in the active region.

In some embodiments, the memory device further includes: a third dielectric layer 224, located on the active region 213 and the second dielectric layer 221, where a contact plug 226 connected to the source region 223 is formed in the third dielectric layer 224; and a fourth dielectric layer 227 located on the third dielectric layer 224, where a capacitor hole exposing the contact plug 226 is formed in the fourth dielectric layer 227, and the capacitor 228 is located in the capacitor hole.

In some embodiments, a material of the metal gate is one or more of W, Al, Cu, Ag, Au, Pt, Ni, Ti, TiN, TaN, Ta, TaC, TaSiN, WN, and Wsi.

It should be noted that the limitations or descriptions of the same or similar structures in this embodiment (memory device) and the foregoing embodiment (the formation process of the memory device) are not repeated in this embodiment. For details, refer to the limitations or descriptions of the corresponding parts in the foregoing embodiment.
Although the present application has been disclosed above with preferred embodiments, these preferred embodiments are not intended to limit the present application. Those skilled in the art can make possible alterations and modifications on the technical solutions of the present application with the methods and technical contents disclosed above without departing from the scope of the present application.

## Claims

1. A method of forming a dynamic random access memory device, comprising:
providing a semiconductor substrate (201), wherein multiple active regions (213) are formed in the semiconductor substrate (201), the multiple active regions (213) are separated by multiple first trenches (214) extending along a first direction and multiple second trenches (215) extending along a second direction, and the first trench (214) communicates with the corresponding second trench (215);
forming, in the semiconductor substrate (201) at a bottom of the first trench (214), a third trench (217) extending along the first direction, wherein a width of the third trench (217) is less than a width of the bottom of the first trench (214);
forming a bit line doped region (218), to act as a bit line, in the semiconductor substrate (201) on two sides of the third trench (217) and at the bottom of the first trench (214) through an ion implantation process;
forming a gate dielectric layer (216) on a sidewall surface and a bottom surface of the first trench (214) and a sidewall surface and a bottom surface of the second trench (215);
forming a first dielectric layer (219) that fills the third trench (217);
forming a metal gate (220) in the second trench (215) and the first trench (214) on the first dielectric layer (219), wherein a top surface of the metal gate (220) is lower than a top surface of the active region (213);
filling the second trench (215) and the first trench (214) above the metal gate (220) with a second dielectric layer (221);
etching a portion of the metal gate (220) in the second trench (215), and segmenting the metal gate (220) in the second trench (215) along the second direction;
forming a source region (223) on the top surface of the active region (213); and
forming, on a surface of the semiconductor substrate (201), a capacitor (228) connected to the source region (223);
wherein the process of forming a bit line doped region (218) in the semiconductor substrate (201) on two sides of the third trench (217) and at the bottom of the first trench (214) through an ion implantation process comprises: forming a fourth mask layer (238) in the third trench (217) and on the top surface of the active region (213), with a seventh opening formed in the fourth mask layer (238), extending along the first direction, and exposing the semiconductor substrate (201) on the two sides of the third trench (217); and performing first ion implantation on the semiconductor substrate (201) at the bottom of the seventh opening along the seventh opening, and forming the bit line doped region (218) in the semiconductor substrate (201) on the two sides of the third trench (217) and at the bottom of the first trench (214); and
wherein impurity ions doped in the bit line doped region (218) are N-type impurity ions or P-type impurity ions.

2. The method of forming the dynamic random access memory device according to claim 1, wherein the multiple active regions (213) are arranged in rows and columns.

3. The method of forming the dynamic random access memory device according to claim 1 or 2, wherein a formation process of the multiple active regions (213) comprises: forming, on the semiconductor substrate (201), multiple first mask patterns (209) extending along the first direction and parallel to each other, with a first opening(210) formed between adjacent first mask patterns (209); forming, on the first mask patterns (209), multiple second mask patterns extending along the second direction and parallel to each other, with a second opening formed between adjacent second mask patterns; etching the first mask pattern (209) along the second opening by using the second mask pattern as a mask and segmenting the first mask pattern (209) along the second direction, and forming multiple discrete block mask patterns (211); and etching the semiconductor substrate (201) by using each of the block mask patterns (211) as a mask, and forming, in the semiconductor substrate (201), the first trench (214) corresponding to the first opening (210) and the second trench (215) corresponding to the second opening, wherein the retained semiconductor substrate (201) between the first trench (214) and the second trench (215) is the multiple active regions (213).

4. The method of forming the dynamic random access memory device according to claim 3, wherein the first mask pattern (209) and the second mask pattern are formed by using a self-aligned double patterning process; and
wherein a formation process of the first mask pattern (209) comprises: forming a first hard mask layer (202) on the semiconductor substrate (201); forming, on the first hard mask layer (202), multiple first strip structures (204) extending along the first direction and arranged parallel to each other; forming a first sacrificial sidewall layer (206) on a sidewall and a top surface of the first strip structure (204) and on the first hard mask layer (202) between the first strip structures (204); filling each portion between the first strip structures (204) with a first filling layer (207); removing the first sacrificial sidewall layer (206) on the sidewall surface of the first strip structure (204), and forming a third opening (208) between the first strip structure (204) and the first filling layer (207); and etching the first hard mask layer (202) along the third opening (208), and forming the first opening (210) in the first hard mask layer (202), and using the retained portion of the first hard mask layer (202) as the first mask pattern (209).

5. The method of forming the dynamic random access memory device according to claim 4, wherein a formation process of the second mask pattern comprises: forming a second hard mask layer on the semiconductor substrate (201) and the first mask pattern (209); forming, on the second hard mask layer, multiple second strip structures arranged in parallel along the second direction; forming a second sacrificial sidewall layer on a sidewall and a top surface of the second strip structure and on a surface of the second hard mask layer between the second strip structures; filling each portion between the second strip structures with a second filling layer; removing the second sacrificial sidewall layer on the sidewall surface of the second strip structure, and forming a fourth opening between the second strip structure and a second filling layer; and etching the second hard mask layer along the fourth opening, and forming the second opening in the second hard mask layer, and using the retained portion of the second hard mask layer as the second mask pattern.

6. The method of forming the dynamic random access memory device according to claim 1, wherein the width of the third trench (217) is 1/4 to 3/4 of the width of the bottom of the first trench (214); and
wherein doping is performed in a well region on the semiconductor substrate (201), and a type of impurity ions doped in the well region is opposite to a type of impurity ions doped in the source region (223) and a type of impurity ions doped in the bit line doped region (218).

7. The method of forming the dynamic random access memory device according to claim 1, wherein a formation process of the third trench (217) comprises: forming a third mask layer in the first trench (214), with a sixth opening formed in the third mask layer, extending along the first direction, and exposing a surface of a portion of the semiconductor substrate (201) at the bottom of the first trench (214); and etching the semiconductor substrate (201) along the sixth opening, and forming the third trench (217).

8. The method of forming the dynamic random access memory device according to claim 1, wherein impurity ions implanted through the first ion implantation are N-type impurity ions or P-type impurity ions, and the first ion implantation has energy of 20 kev to 100 kev, a dose of 1E13 to 1E22 atom/cm2, and an angle of 0 to 20 degrees; and
wherein the source region (223) is formed through second ion implantation, and a type of impurity ions implanted in the source region (223) is the same as a type of impurity ions implanted in the bit line doped region (218).

9. The method of forming the dynamic random access memory device according to claim 1, wherein the process of forming, on a surface of the semiconductor substrate (201), a capacitor (228) connected to the source region (223) comprises: forming a third dielectric layer (224) on the active region (213) and the second dielectric layer (221); forming, in the third dielectric layer (224), a through hole (225) exposing a surface of the source region (223); forming a contact plug (226) in the through hole (225); forming a fourth dielectric layer (227) on the third dielectric layer (224); forming, in the fourth dielectric layer (227), a capacitor hole (229) exposing the contact plug (226); and forming the capacitor (228) in the capacitor hole (229).

## Patentansprüche

1. Verfahren zum Bilden einer dynamischen Direktzugriffsspeichervorrichtung, umfassend:
Bereitstellen eines Halbleitersubstrats (201), wobei mehrere aktive Bereiche (213) in dem Halbleitersubstrat (201) ausgebildet sind, die mehreren aktiven Bereiche (213) durch mehrere erste Gräben (214), die sich entlang einer ersten Richtung erstrecken, und mehrere zweite Gräben (215), die sich entlang einer zweiten Richtung erstrecken, getrennt sind, und der erste Graben (214) mit dem entsprechenden zweiten Graben (215) in Verbindung ist;
Bilden eines dritten Grabens (217) in dem Halbleitersubstrat (201) an einem Boden des ersten Grabens (214), der sich entlang der ersten Richtung erstreckt, wobei eine Breite des dritten Grabens (217) geringer ist als eine Breite des Bodens des ersten Grabens (214);
Bilden eines bitleitungsdotierten Bereichs (218), um als Bitleitung zu wirken, in dem Halbleitersubstrat (201) auf zwei Seiten des dritten Grabens (217) und an dem Boden des ersten Grabens (214) durch einen Ionenimplantationsprozess;
Bilden einer dielektrischen Gate-Schicht (216) auf einer Seitenwandfläche und einer Bodenfläche des ersten Grabens (214) und einer Seitenwandfläche und einer Bodenfläche des zweiten Grabens (215);
Bilden einer ersten dielektrischen Schicht (219), die den dritten Graben (217) füllt;
Bilden eines Metall-Gates (220) in dem zweiten Graben (215) und dem ersten Graben (214) auf der ersten dielektrischen Schicht (219), wobei eine obere Oberfläche des Metall-Gates (220) niedriger ist als eine obere Oberfläche des aktiven Bereichs (213);
Füllen des zweiten Grabens (215) und des ersten Grabens (214) oberhalb des Metall-Gates (220) mit einer zweiten dielektrischen Schicht (221);
Ätzen eines Abschnitts des Metall-Gates (220) in dem zweiten Graben (215) und Segmentieren des Metall-Gates (220) in dem zweiten Graben (215) entlang der zweiten Richtung;
Bilden eines Source-Bereichs (223) auf der oberen Oberfläche des aktiven Bereichs (213); und
Bilden, auf einer Oberfläche des Halbleitersubstrats (201), eines Kondensators (228), der mit dem Source-Bereich (223) verbunden ist;
wobei
ein Bilden eines bitleitungsdotierten Bereichs (218) in dem Halbleitersubstrat (201) auf zwei Seiten des dritten Grabens (217) und an dem Boden des ersten Grabens (214) durch einen lonenimplantationsprozess Folgendes umfasst: Bilden einer vierten Maskenschicht (238) in dem dritten Graben (217) und auf der oberen Oberfläche des aktiven Bereichs (213), wobei eine siebte Öffnung in der vierten Maskenschicht (238) gebildet ist, die sich entlang der ersten Richtung erstreckt und das Halbleitersubstrat (201) auf den beiden Seiten des dritten Grabens (217) freilegt; und Durchführen einer ersten Ionenimplantation auf dem Halbleitersubstrat (201) an dem Boden der siebten Öffnung entlang der siebten Öffnung und Bilden des bitleitungsdotierten Bereichs (218) in dem Halbleitersubstrat (201) auf den beiden Seiten des dritten Grabens (217) und an dem Boden des ersten Grabens (214); und
wobei in den bitleitungsdotierten Bereich (218) dotierte Störstellenionen N-Typ-Störstellenionen oder P-Typ-Störstellenionen sind.

2. Verfahren zum Bilden der dynamischen Direktzugriffsspeichervorrichtung nach Anspruch 1, wobei die mehreren aktiven Bereiche (213) in Zeilen und Spalten angeordnet sind.

3. Verfahren zum Bilden der dynamischen Direktzugriffsspeichervorrichtung nach Anspruch 1 oder 2, wobei ein Bildungsprozess der mehreren aktiven Bereiche (213) Folgendes umfasst: Bilden, auf dem Halbleitersubstrat (201), mehrerer erster Maskenmuster (209), die sich entlang der ersten Richtung und parallel zueinander erstrecken, wobei eine erste Öffnung (210) zwischen angrenzenden ersten Maskenmustern (209) gebildet ist; Bilden, auf den ersten Maskenmustern (209), mehrerer zweiter Maskenmuster, die sich entlang der zweiten Richtung und parallel zueinander erstrecken, wobei zwischen angrenzenden zweiten Maskenmustern eine zweite Öffnung gebildet ist; Ätzen des ersten Maskenmusters (209) entlang der zweiten Öffnung unter Verwendung des zweiten Maskenmusters als Maske und Segmentieren des ersten Maskenmusters (209) entlang der zweiten Richtung, und Bilden mehrerer separater Blockmaskenmuster (211); und Ätzen des Halbleitersubstrats (201) unter Verwendung jedes der Blockmaskenmuster (211) als Maske, und Bilden, in dem Halbleitersubstrat (201), des ersten Grabens (214), der der ersten Öffnung (210) entspricht, und des zweiten Grabens (215), der der zweiten Öffnung entspricht, wobei das beibehaltene Halbleitersubstrat (201) zwischen dem ersten Graben (214) und dem zweiten Graben (215) die mehreren aktiven Bereiche (213) sind.

4. Verfahren zum Bilden der dynamischen Direktzugriffsspeichervorrichtung nach Anspruch 3, wobei das erste Maskenmuster (209) und das zweite Maskenmuster unter Verwendung eines selbstausgerichteten Doppelmusterungsprozesses gebildet werden; und
wobei ein Bildungsprozess des ersten Maskenmusters (209) Folgendes umfasst: Bilden einer ersten Hartmaskenschicht (202) auf dem Halbleitersubstrat (201); Bilden, auf der ersten Hartmaskenschicht (202), mehrerer erster Streifenstrukturen (204), die sich entlang der ersten Richtung erstrecken und parallel zueinander angeordnet sind; Bilden einer ersten Opfer-Seitenwandschicht (206) auf einer Seitenwand und einer oberen Oberfläche der ersten Streifenstruktur (204) und auf der ersten Hartmaskenschicht (202) zwischen den ersten Streifenstrukturen (204); Füllen jedes Abschnitts zwischen den ersten Streifenstrukturen (204) mit einer ersten Füllschicht (207); Entfernen der ersten Opfer-Seitenwandschicht (206) auf der Seitenwandfläche der ersten Streifenstruktur (204) und Bilden einer dritten Öffnung (208) zwischen der ersten Streifenstruktur (204) und der ersten Füllschicht (207); und Ätzen der ersten Hartmaskenschicht (202) entlang der dritten Öffnung (208) und Bilden der ersten Öffnung (210) in der ersten Hartmaskenschicht (202) und Verwenden des beibehaltenen Abschnitts der ersten Hartmaskenschicht (202) als das erste Maskenmuster (209).

5. Verfahren zum Bilden der dynamischen Direktzugriffsspeichervorrichtung nach Anspruch 4, wobei ein Bildungsprozess des zweiten Maskenmusters Folgendes umfasst: Bilden einer zweiten Hartmaskenschicht auf dem Halbleitersubstrat (201) und dem ersten Maskenmuster (209); Bilden, auf der zweiten Hartmaskenschicht, mehrerer zweiter Streifenstrukturen, die parallel entlang der zweiten Richtung angeordnet sind; Bilden einer zweiten Opfer-Seitenwandschicht auf einer Seitenwand und einer oberen Oberfläche der zweiten Streifenstruktur und auf einer Oberfläche der zweiten Hartmaskenschicht zwischen den zweiten Streifenstrukturen; Füllen jedes Abschnitts zwischen den zweiten Streifenstrukturen mit einer zweiten Füllschicht; Entfernen der zweiten Opfer-Seitenwandschicht auf der Seitenwandfläche der zweiten Streifenstruktur und Bilden einer vierten Öffnung zwischen der zweiten Streifenstruktur und der zweiten Füllschicht; und Ätzen der zweiten Hartmaskenschicht entlang der vierten Öffnung und Bilden der zweiten Öffnung in der zweiten Hartmaskenschicht und Verwenden des beibehaltenen Abschnitts der zweiten Hartmaskenschicht als das zweite Maskenmuster.

6. Verfahren zum Bilden der dynamischen Direktzugriffsspeichervorrichtung nach Anspruch 1, wobei die Breite des dritten Grabens (217) 1/4 bis 3/4 der Breite des Bodens des ersten Grabens (214) ist; und
wobei ein Dotieren in einem Wannenbereich auf dem Halbleitersubstrat (201) durchgeführt wird und ein Typ von Störstellenionen, die in dem Wannenbereich dotiert sind, entgegengesetzt zu einem Typ von Störstellenionen ist, die in dem Source-Bereich (223) dotiert sind, und einem Typ von Störstellenionen, die in dem bitleitungsdotierten Bereich (218) dotiert sind.

7. Verfahren zum Bilden der dynamischen Direktzugriffsspeichervorrichtung nach Anspruch 1, wobei ein Bildungsprozess des dritten Grabens (217) Folgendes umfasst: Bilden einer dritten Maskenschicht in dem ersten Graben (214), wobei eine sechste Öffnung in der dritten Maskenschicht gebildet ist, die sich entlang der ersten Richtung erstreckt und eine Oberfläche eines Abschnitts des Halbleitersubstrats (201) an dem Boden des ersten Grabens (214) freilegt; und Ätzen des Halbleitersubstrats (201) entlang der sechsten Öffnung und Bilden des dritten Grabens (217).

8. Verfahren zum Bilden der dynamischen Direktzugriffsspeichervorrichtung nach Anspruch 1, wobei die Störstellenionen, die durch die erste Ionenimplantation implantiert werden, vom N-Typ oder Störstellenionen vom P-Typ sind und die erste Ionenimplantation eine Energie von 20 kev bis 100 kev, eine Dosis von 1E13 bis 1E22 Atom/cm² und einen Winkel von 0 bis 20 Grad aufweist; und
wobei der Source-Bereich (223) durch eine zweite Ionenimplantation gebildet wird und ein Typ von Störstellenionen, die in den Source-Bereich (223) implantiert werden, gleich ist wie ein Typ von Störstellenionen, die in den bitleitungsdotierten Bereich (218) implantiert werden.

9. Verfahren zum Bilden der dynamischen Direktzugriffsspeichervorrichtung nach Anspruch 1, wobei der Bildungsprozess, auf einer Oberfläche des Halbleitersubstrats (201), eines Kondensators (228), der mit dem Source-Bereich (223) verbunden ist, Folgendes umfasst: Bilden einer dritten dielektrischen Schicht (224) auf dem aktiven Bereich (213) und der zweiten dielektrischen Schicht (221); Bilden, in der dritten dielektrischen Schicht (224), eines Durchgangslochs (225) das eine Oberfläche des Source-Bereichs (223) freilegt; Bilden eines Kontaktstopfens (226) in dem Durchgangsloch (225); Bilden einer vierten dielektrischen Schicht (227) auf der dritten dielektrischen Schicht (224); Bilden, in der vierten dielektrischen Schicht (227), eines Kondensatorlochs (229) das den Kontaktstopfen (226) freilegt; und Bilden des Kondensators (228) in dem Kondensatorloch (229).

## Revendications

1. Procédé de formation d'un dispositif de mémoire vive dynamique, comprenant :
la fourniture d'un substrat semi-conducteur (201), dans lequel de multiples régions actives (213) sont formées dans le substrat semi-conducteur (201), les multiples régions actives (213) sont séparées par de multiples premières tranchées (214) s'étendant dans une première direction et de multiples deuxièmes tranchées (215) s'étendant dans une seconde direction, et la première tranchée (214) communique avec la deuxième tranchée (215) correspondante ;
la formation, dans le substrat semi-conducteur (201) au fond de la première tranchée (214), d'une troisième tranchée (217) s'étendant dans la première direction, dans lequel une largeur de la troisième tranchée (217) est inférieure à une largeur du fond de la première tranchée (214) ;
la formation d'une région dopée de ligne de bits (218), pour agir comme une ligne de bits, dans le substrat semi-conducteur (201) sur deux côtés de la troisième tranchée (217) et au fond de la première tranchée (214) par un processus d'implantation ionique ;
la formation d'une couche diélectrique de grille (216) sur une surface de paroi latérale et une surface inférieure de la première tranchée (214) et sur une surface de paroi latérale et une surface inférieure de la deuxième tranchée (215) ;
la formation d'une première couche diélectrique (219) qui remplit la troisième tranchée (217) ;
la formation d'une grille métallique (220) dans la deuxième tranchée (215) et la première tranchée (214) sur la première couche diélectrique (219), dans lequel une surface supérieure de la grille métallique (220) est inférieure à une surface supérieure de la région active (213) ;
le remplissage de la deuxième tranchée (215) et de la première tranchée (214) au-dessus de la grille métallique (220) avec une deuxième couche diélectrique (221) ;
la gravure d'une partie de la grille métallique (220) dans la deuxième tranchée (215), et segmentation de la grille métallique (220) dans la deuxième tranchée (215) dans la seconde direction ;
la formation d'une région de source (223) sur la surface supérieure de la région active (213) ; et
la formation, sur une surface du substrat semi-conducteur (201), d'un condensateur (228) connecté à la région de source (223) ;
dans lequel le procédé de formation d'une région dopée de ligne de bits (218) dans le substrat semi-conducteur (201) sur deux côtés de la troisième tranchée (217) et au fond de la première tranchée (214) par un procédé d'implantation ionique comprend : la formation d'une quatrième couche de masque (238) dans la troisième tranchée (217) et sur la surface supérieure de la région active (213), avec une septième ouverture formée dans la quatrième couche de masque (238), s'étendant dans la première direction, et l'exposition du substrat semi-conducteur (201) sur les deux côtés de la troisième tranchée (217) ; et la réalisation d'une première implantation ionique sur le substrat semi-conducteur (201) au fond de la septième ouverture le long de la septième ouverture, et la formation de la région dopée de ligne de bits (218) dans le substrat semi-conducteur (201) sur les deux côtés de la troisième tranchée (217) et au fond de la première tranchée (214) ; et
dans lequel les ions d'impureté dopés dans la région dopée de ligne de bits (218) sont des ions d'impureté de type N ou des ions d'impureté de type P.

2. Procédé de formation du dispositif de mémoire vive dynamique selon la revendication 1, dans lequel les multiples régions actives (213) sont agencées en lignes et en colonnes.

3. Procédé de formation du dispositif de mémoire vive dynamique selon la revendication 1 ou 2, dans lequel un procédé de formation des multiples régions actives (213) comprend : la formation, sur le substrat semi-conducteur (201), de multiples premiers motifs de masque (209) s'étendant dans la première direction et parallèles les uns aux autres, avec une première ouverture (210) formée entre les premiers motifs de masque (209) adjacents ; la formation, sur les premiers motifs de masque (209), de multiples seconds motifs de masque s'étendant dans la seconde direction et parallèles les uns aux autres, avec une deuxième ouverture formée entre les seconds motifs de masque adjacents ; la gravure du premier motif de masque (209) le long de la deuxième ouverture en utilisant le second motif de masque comme un masque et en segmentant le premier motif de masque (209) dans la seconde direction, et la formation de multiples motifs de masque en blocs (211) distincts ; et la gravure du substrat semi-conducteur (201) en utilisant chacun des motifs de masque en blocs (211) comme un masque, et la formation, dans le substrat semi-conducteur (201), de la première tranchée (214) correspondant à la première ouverture (210) et de la deuxième tranchée (215) correspondant à la deuxième ouverture, dans lequel le substrat semi-conducteur (201) conservé entre la première tranchée (214) et la deuxième tranchée (215) correspond aux multiples régions actives (213).

4. Procédé de formation du dispositif de mémoire vive dynamique selon la revendication 3, dans lequel le premier motif de masque (209) et le second motif de masque sont formés à l'aide d'un processus de double modelage auto-aligné ; et
dans lequel un processus de formation du premier motif de masque (209) comprend : la formation d'une première couche de masque dur (202) sur le substrat semi-conducteur (201) ; la formation, sur la première couche de masque dur (202), de multiples premières structures en bande (204) s'étendant dans la première direction et agencées parallèlement les unes aux autres ; la formation d'une première couche de paroi latérale sacrificielle (206) sur une paroi latérale et une surface supérieure de la première structure en bande (204) et sur la première couche de masque dur (202) entre les premières structures en bande (204) ; le remplissage de chaque partie entre les premières structures en bande (204) avec une première couche de remplissage (207) ; le retrait de la première couche de paroi latérale sacrificielle (206) sur la surface de paroi latérale de la première structure en bande (204), et la formation d'une troisième ouverture (208) entre la première structure en bande (204) et la première couche de remplissage (207) ; et la gravure de la première couche de masque dur (202) le long de la troisième ouverture (208), et la formation de la première ouverture (210) dans la première couche de masque dur (202), et l'utilisation de la partie conservée de la première couche de masque dur (202) comme le premier motif de masque (209).

5. Procédé de formation du dispositif de mémoire vive dynamique selon la revendication 4, dans lequel un processus de formation du second motif de masque comprend : la formation d'une seconde couche de masque dur sur le substrat semi-conducteur (201) et le premier motif de masque (209) ; la formation, sur la seconde couche de masque dur, de multiples secondes structures en bande agencées parallèlement dans la seconde direction ; la formation d'une seconde couche de paroi latérale sacrificielle sur une paroi latérale et une surface supérieure de la seconde structure en bande et sur une surface de la seconde couche de masque dur entre les secondes structures en bande ; le remplissage de chaque partie entre les secondes structures en bande avec une seconde couche de remplissage ; le retrait de la seconde couche de paroi latérale sacrificielle sur la surface de paroi latérale des secondes structures en bande, et la formation d'une quatrième ouverture entre la seconde structure en bande et la seconde couche de remplissage ; et la gravure de la seconde couche de masque dur le long de la quatrième ouverture, et la formation de la deuxième ouverture dans seconde couche de masque dur, et l'utilisation de la partie conservée de la seconde couche de masque dur comme le second motif de masque.

6. Procédé de fabrication du dispositif de mémoire vive dynamique selon la revendication 1, dans lequel la largeur de la troisième tranchée (217) est de 1/4 à 3/4 de la largeur du fond de la première tranchée (214) ; et
dans lequel le dopage est effectué dans une région de puits sur le substrat semi-conducteur (201), et un type d'ions d'impureté dopés dans la région de puits est opposé à un type d'ions d'impureté dopés dans la région de source (223) et à un type d'ions d'impureté dopés dans la région dopée de ligne de bits (218).

7. Procédé de formation du dispositif de mémoire vive dynamique selon la revendication 1, dans lequel un processus de formation de la troisième tranchée (217) comprend : la formation d'une troisième couche de masque dans la première tranchée (214), avec une sixième ouverture formée dans la troisième couche de masque, s'étendant dans la première direction, et l'exposition d'une surface d'une partie du substrat semi-conducteur (201) au fond de la première tranchée (214) ; et la gravure du substrat semi-conducteur (201) le long de la sixième ouverture, et la formation de la troisième tranchée (217).

8. Procédé de formation du dispositif de mémoire vive dynamique selon la revendication 1, dans lequel les ions d'impureté implantés par la première implantation ionique sont des ions d'impureté de type N ou P, et la première implantation ionique a une énergie de 20 keV à 100 keV, une dose de 1E13 à 1E22 atomes/cm², et un angle de 0 à 20 degrés ; et
dans lequel la région de source (223) est formée par une seconde implantation ionique, et un type d'ions d'impureté implantés dans la région de source (223) est le même qu'un type d'ions d'impureté implantés dans la région dopée de ligne de bits (218).

9. Procédé de formation du dispositif de mémoire vive dynamique selon la revendication 1, dans lequel le processus de formation, sur une surface du substrat semi-conducteur (201), d'un condensateur (228) connecté à la région de source (223) comprend : la formation d'une troisième couche diélectrique (224) sur la région active (213) et la deuxième couche diélectrique (221) ; la formation, dans la troisième couche diélectrique (224), d'un trou traversant (225) exposant une surface de la région de source (223) ; la formation d'une fiche de contact (226) dans le trou traversant (225) ; la formation d'une quatrième couche diélectrique (227) sur la troisième couche diélectrique (224) ; la formation, dans la quatrième couche diélectrique (227), d'un trou de condensateur (229) exposant la fiche de contact (226) ; et la formation du condensateur (228) dans le trou de condensateur (229).
